# EUROPÄISCHE PATENTSCHRIFT

(11) **EP 2 958 139 B1**
(45) Veröffentlichungstag und Bekanntmachung des Hinweises auf die Patenterteilung: **05.08.2020**
(21) Anmeldenummer: 14172876.6
(22) Anmeldetag: 18.06.2014
(51) Int. Cl.: H01L 23/29, H01L 23/31, H01L 23/373, H01L 23/473, H01L 23/367

(54) **Verfahren zur Herstellung eines Halbleitermoduls**
Method of manufacturing a semiconductor module
Procédé de fabrication d'un module à semi-conducteurs

(43) Veröffentlichungstag der Anmeldung: 23.12.2015
(73) Patentinhaber: Heraeus Deutschland GmbH & Co. KG, 63450 Hanau (DE)
(72) Erfinder: Eisele, Ronald, 24229 Surendorf (DE); Miric, Anton-Zoran, 63755 Alzenau (DE); Krüger, Frank, 61130 Nidderau (DE); Schmitt, Wolfgang, 63110 Rodgau (DE)
(74) Vertreter: Heraeus IP

(56) Entgegenhaltungen:
- DE-A1- 1 514 413
- DE-A1-102008 007 021
- DE-A1-102013 102 058
- JP-A- S60 226 149
- US-A1- 2009 047 797
- US-A1- 2010 090 335
- US-A1- 2011 124 483

## Beschreibung

Die Erfindung betrifft ein Verfahren zur Herstellung eines als leistungselektronische Baugruppe ausgebildeten Halbleitermoduls mit einer mindestens einen Halbleiterbaustein (Halbleiter) bedeckenden Umhüllungsmasse.

Das Umhüllen von Einzel-Halbleitern und Halbleiter-Baugruppen (inkl. passiver Bauelemente) auf Substraten (Keramik-, Metall- und Organikkernleiterplatten) geschieht heute vorzugsweise durch organische Massen beispielsweise auf Epoxidharzbasis mit z.T. anorganischen Füllstoffen, wie Siliziumdioxid (SiO₂). Beispielsweise offenbart US 4,529,755 eine derartige Umhüllungsmasse umfassend eine polyfunktionelle Epoxidverbindung, ein Styrolblockcopolymer, einen Härter für die Epoxidverbindung und einen anorganischen Füllstoff.

Diese umhüllten Bauelemente und Baugruppen haben typischerweise elektrische Anschlüsse und Kühlanschlussflächen für die eingebauten Leistungsbauelemente.

Für leistungselektronische Anwendungen stehen Bauelemente und Baugruppen mit hohen Verlustleistungen und zum Teil auch hohen Betriebsspannungen, also Isolationsanforderungen im Mittelpunkt. In leistungselektronischen Bauelementen und Baugruppen werden als Schaltungsträger überwiegend keramische Substrate mit Kernen aus Aluminiumoxid, Aluminiumnitrid oder Siliziumnitrid eingesetzt.

DE 10 2013 102058 A1 offenbart ein Verfahren zur Herstellung eines Halbleitermoduls mit einem mindestens einen Halbleiterbaustein tragenden keramischen Schaltungsträger. Der mindestens einen Halbleiterbaustein ist von einer ausgehärteten anorganischen Umhüllungsmasse bedeckt. Die Keramik des keramischen Schaltungsträgers basiert auf Aluminiumoxid, Aluminiumnitrid oder Siliziumnitrid.

Aus DE 15 14 413 A1 ist ein Halbleitermodul bekannt mit einer einen Halbleiterbaustein bedeckenden Zementumhüllungsmasse, wobei die Umhüllungsmasse Zement ist. Als geeignete Materialien werden z.B. Gemische aus Magnesiumoxid und Magnesiumchlorid oder aus Zinkoxid und Zinkchlorid erwähnt.

US 2011/124483 A1 offenbart eine Keramikmatrix und ein mit Kohlenstoffnanoröhren infundiertes Fasermaterial umfassendes Verbundmaterial. Die Keramikmatrix kann einen Zement umfassen. Als Zemente werden Portlandzement, Pozzolan-Kalk-Zement, Schlackenkalk-Zement, supersulfatierter Zement, Calciumaluminat-Zement, Calciumsulfoaluminat-Zement, Zemente auf Carbidbasis, feuerfeste Zemente, Chrom-Aluminiumoxidzemente und Nickel-Magnesiumoxid-Eisen-Zirkoniumcarbid-Zemente genannt.

US 7,034,660 B2 offenbart einen drahtlos arbeitenden Sensor, der in Beton oder einem anderen zementhaltigen Material eingebettet ist, um Parameter zu erfassen, die auf Veränderungen in der Bausubstanz hindeuten. Beispielsweise kann es sich bei dem Sensor um einen zur Erfassung von Chloridionen geeigneten elektrochemischen Sensor handeln.

Aufgabe der vorliegenden Erfindung ist es ein Verfahren zur Herstellung eines als leistungselektronische Baugruppe ausgebildeten Halbleitermoduls mit einer als glob-top ausgebildeten Umhüllung bereitzustellen, wobei das Auftreten unerwünschter Phänomene wie Delamination oder Zerstörung von Kontaktierungselementen wie Bonddrähten beim Verfahrensprodukt vermieden werden soll.

Diese Aufgabe wird gelöst durch ein Verfahren zur Herstellung eines als leistungselektronische Baugruppe ausgebildeten Halbleitermoduls (10) mit einem mindestens einen Halbleiterbaustein (20) tragenden keramischen Schaltungsträger (50),
wobei der mindestens eine Halbleiterbaustein (20) von einer einen ausgehärteten anorganischen Zement umfassenden Umhüllungsmasse (30) bedeckt ist,
wobei die Umhüllungsmasse (30) einen thermischen Ausdehnungskoeffizienten im Bereich von 2 bis 10 ppm/K aufweist und
wobei die Keramik des keramischen Schaltungsträgers (50) ausgewählt ist aus der Gruppe, die aus auf Aluminiumoxid, Aluminiumnitrid oder Siliziumnitrid basierenden Keramiken besteht,
umfassend die Bildung des ausgehärteten anorganischen Zements durch die Schritte:
(1) Vermischen eines pulverförmigen Gemischs aus anorganischem Bindemittel und anorganischen Zuschlagstoffen mit Wasser zu einer gießfähigen Masse,
(2) Vergießen der so gebildeten gießfähigen Masse, und
(3) folgend Abbinden und Trocknung der vergossenen Masse,
wobei das pulverförmige Gemisch aus anorganischem Bindemittel und anorganischen Zuschlagstoffen ein Magnesiumphosphatzement ist,
wobei der Halbleiterbaustein (20) auf dem keramischen Schaltungsträger (50) befestigt ist,
wobei das Halbleitermodul (10) einen Rahmen (60) als Träger von nach außen geführten elektrischen Kontakten aufweist,
wobei der keramische Schaltungsträger (50) auf der Oberseite einer Wärmespreizplatte (70) aufgebracht ist, deren Unterseite mit einem Kühlkörper (80) verbunden ist, wobei die Umhüllungsmasse (30) als "glob-top" ausgebildet ist,
wobei die den Halbleiterbaustein (20) kontaktierenden Bonddrähte (40) mit der Umhüllungsmasse (30) zumindest teilweise bedeckt sind,
wobei der "glob-top" und die weiteren Oberflächenbereiche des Halbleitermoduls (10) von einer Isolationsmasse (90) bedeckt sind.

Abgesehen von seiner speziellen Umhüllungsmasse (30) handelt es sich bei dem Halbleitermodul (10) um ein an sich übliches Halbleitermodul, das einen keramischen Schaltungsträger (keramisches Substrat) (50), welcher einen oder mehrere Halbleiterbausteine (20) trägt, umfasst. Bei dem oder den Halbleiterbausteinen (20) handelt es sich insbesondere um während des bestimmungsgemäßen Betriebs infolge Verlustleistung beträchtliche Wärme entwickelnde, d.h. ohne Umhüllung und unverkapselt selbstzerstörerische Temperaturen von beispielsweise 150 bis > 200°C erreichende Halbleiter, wie sie in leistungselektronischen Baugruppen Anwendung finden; insbesondere handelt es sich bei dem oder den Halbleiterbausteinen (20) nicht um Sensoren oder Messfühler. Bei der Keramik des Schaltungsträgers (50) handelt es sich um eine Keramik, die ausgewählt ist aus der Gruppe, die aus auf Aluminiumoxid, Aluminiumnitrid oder Siliziumnitrid basierenden Keramiken besteht. Mit anderen Worten, es handelt sich um eine Keramik mit 95 bis 100 Gewichtsprozent Aluminiumoxid-, Aluminiumnitrid- oder Siliziumnitridanteil.

Die Umhüllungsmasse (30) ist ein im Wesentlichen oder vollständig anorganisches, metallfreies Material. Sie hat einen thermischen Ausdehnungskoeffizienten im Bereich von 2 bis 10 ppm/K. Die Umhüllungsmasse (30) umfasst einen ausgehärteten anorganischen Zement.

Mit anderen Worten, die Umhüllungsmasse (30) besteht aus einem ausgehärteten anorganischen Zement oder sie umfasst neben dem eine Matrix bildenden, ausgehärteten anorganischen Zement einen oder mehrere weitere Bestandteile. Letztere sind bevorzugt elektrisch nichtleitend.

Der die Matrix der Umhüllungsmasse (30) oder die Umhüllungsmasse (30) als solche bildende ausgehärtete anorganische Zement hat einen thermischen Ausdehnungskoeffizienten im Bereich von 2 bis 10 ppm/K. Der ausgehärtete anorganische Zement wird gebildet durch Vermischen eines pulverförmigen Gemischs aus anorganischem Bindemittel und anorganischen Zuschlagstoffen mit Wasser zu einer gießfähigen Masse, Vergießen der so gebildeten gießfähigen Masse, gefolgt von Abbinden und Trocknung der vergossenen Masse.

Bei dem pulverförmigen Gemisch aus anorganischem Bindemittel und anorganischen Zuschlagstoffen handelt es sich um einen Magnesiumphosphatzement, insbesondere um Magnesiumoxid und Zirkoniumsilikat enthaltenden Magnesiumphosphatzement. Ein Beispiel für solche Materialien ist das unter der Bezeichnung ZIRCON POTTING CEMENT NO.13 von der Firma Sauereisen vertriebene Produkt.

Das schon erwähnte Vergießen der durch Vermischen eines geeigneten pulverförmigen Gemischs aus anorganischem Bindemittel und anorganischen Zuschlagstoffen mit Wasser gebildeten gießfähigen Masse kann mittels üblichen, dem Fachmann bekannten Methoden erfolgen, beispielsweise durch Schwerkraft- oder druckbeaufschlagten Verguss. Dabei kann es zweckmäßig sein, das zu umhüllende Bauteil bzw. die zu umhüllende Baugruppe mit Halbschalenformen zu umschließen und dann mit der gießfähigen Masse zu füllen. Nach Abbinden und Trocknung kann das umhüllte Bauteil bzw. die umhüllte Baugruppe nach Öffnen der Halbschalen entnommen werden.

Das Vergießen erfolgt so, dass die Umhüllungsmasse (30) als dem Fachmann bekanntes "glob-top" ausgebildet wird. Es wird so durchgeführt, dass die Umhüllungsmasse (30) mit dem Halbleiterbaustein (20) verbundene Bonddrähte (40) teilweise oder vollständig umhüllt. Teilweise Umhüllung bedeutet, dass ein oder mehrere der Bonddrähte (40) unvollständig umhüllt sind, während vollständige Umhüllung bedeutet, dass alle Bonddrähte (40) vollständig umhüllt sind.

Abbinden und Trocknung erfolgen während beispielsweise 30 bis 120 Minuten in einem Temperaturbereich von 20 bis 120 °C. Während des Abbindens und Trocknens härtet der anorganische Zement aus.

Wie schon gesagt, die Umhüllungsmasse (30) kann aus dem ausgehärteten anorganischen Zement bestehen oder neben dem als Matrixbildner dienenden, ausgehärteten anorganischen Zement einen oder mehrere weitere Bestandteile umfassen. Im letzteren Falle sind der oder die weiteren Bestandteile der gießfähigen Masse vor dem Vergießen hinzuzufügen, d.h. vor und/oder nach der Wasserzugabe hinzuzumischen. Der oder die weiteren Bestandteile können also dem pulverförmigen Gemisch aus anorganischem Bindemittel und anorganischen Zuschlagstoffen hinzugemischt werden, bevor mit Wasser zu einer gießfähigen Masse vermischt wird oder das Hinzumischen erfolgt nach der Wasserzugabe. Es ist aber auch möglich, einen Teil der Bestandteile vor und den verbleibenden Teil nach der Wasserzugabe hinzuzumischen.

Beispiele für neben dem ausgehärteten anorganischen Zement mögliche, von der Umhüllungsmasse (30) umfasste Bestandteile sind Aluminiumnitridpartikel, Bornitridpartikel, Aluminiumoxidpartikel und/oder Siliziumnitridpartikel in einem Gesamtvolumenanteil von beispielsweise 25 bis 90 Volumen-%, bezogen auf das Volumen der Umhüllungsmasse (30).
Die Anwesenheit solcher Partikel in der Umhüllungsmasse (30) wirkt sich günstig auf deren Wärmeleitfähigkeit aus. Beispiele für geeignete Aluminiumnitridpartikel sind solche mit einer durch Laserdiffraktion bestimmten mittleren Partikelgröße (d50) im Bereich von 0,8 bis 11 µm, wie sie beispielsweise von Fa. H.C.Starck kommerziell vertrieben werden.

Weitere Beispiele für neben dem ausgehärteten anorganischen Zement mögliche, von der Umhüllungsmasse (30) umfasste Bestandteile sind Fasern, d.h. es können eine oder mehrere verschiedene Arten von Fasern von der Umhüllungsmasse (30) umfasst sein. Beispielsweise kann der Anteil von Fasern im Bereich von bis zu 20 Volumenprozent, beispielsweise im Bereich von 10 bis 20 Volumenprozent liegen. Beispiele für verwendbare Fasern sind anorganische Fasern wie Glasfasern, Basaltfasern, Borfasern und keramische Fasern, beispielsweise Siliziumkarbidfasern und Aluminiumoxidfasern, aber auch hochschmelzende, organische Fasern wie beispielsweise Aramidfasern. Die Anwesenheit solcher Fasern in der Umhüllungsmasse (30) wirkt sich günstig auf deren Zugspannungsfestigkeit und Temperaturwechselfestigkeit aus.

In einer Ausführungsform sind alle mit der Umhüllungsmasse (30) in Kontakt kommenden Oberflächen nicht unbeschichtet, sondern mit einer haftvermittelnden Überzugsschicht (Primerschicht) versehen, beispielsweise mit einer aus einer Polyacrylatdispersion beispielweise durch Sprühauftrag aufgebrachten Überzugschicht.

Die Umhüllungsmasse (30) kann eine Restporosität aufweisen, weshalb in einer Ausführungsform ein feuchtebeständiger Überzug vorgesehen sein kann. Beispielsweise können die Kapillaren durch niedrigviskose Schutzmassen verfüllt werden, welche dauerhaft die Kapillaren abdichten. Dazu sind insbesondere wässrige Lösungen von Kalium- oder Lithiumsilikaten geeignet. Man kann die äußere Oberfläche der Umhüllungsmasse (30) aber auch mit einer Schutzschicht, die nicht oder nur gering von Feuchtigkeit penetriert wird, überziehen. Dazu können beispielsweise Beschichtungsmittel auf Basis härtbarer Epoxydharze verwendet werden.

Die stoffliche Fügemöglichkeit der Umhüllungsmasse (30) ermöglicht eine bevorzugte Wärmeleitung vom verlustleistungsbehafteten Halbleiter (20) über die Umhüllungsmasse (30) zu einem Kühlkörper (80). Dies kann sowohl einseitig, wie auch - ausgehend vom Halbleiter (20) - mehrseitig sein. Bevorzugt stellt die Umhüllungsmasse (30) daher eine Wärmebrücke dar, die den thermischen Pfad zu einem oder mehreren insbesondere metallischen Kühlkörpern (80) beispielsweise aus Aluminium oder Kupfer herstellt. Die Wärmeabfuhr erfolgt durch die Umhüllungsmasse (30) zur äußeren Oberfläche der umhüllten Baugruppe zu beispielsweise besagten Kühlkörpern (80) und/oder durch Wärmeabstrahlung. Begünstigend für die Wärmeabfuhr kann es sein, wenn die stoffliche Verbindung zwischen der Umhüllungsmasse (30) und dem oder den Kühlkörpern (80), dem Halbleiter (20) und dem keramischen Schaltungsträger (50) eine chemische Bindung umfasst. So kann durch eine einerseits substratverbundene Kühlung und eine mit der Umhüllungsmasse (30) verbundene Kühlung für mehrseitige Abfuhr von Wärme gesorgt werden. Die Erfindung wird anhand von in den Zeichnungen dargestellten Beispielen für Halbleitermodule näher erläutert. Die Zeichnungen 2 bis 5 zeigen Beispiele für nicht nach dem erfindungsgemäßen Verfahren hergestellte Halbleitermodule, sie sollen das Verständnis der Erfindung erleichtern. Es zeigen:
- Fig. 1: den schematischen Aufbau eines nach dem erfindungsgemäßen Verfahren herstellbaren Halbleitermoduls (10) gemäß einem Ausführungsbeispiel, bei dem die Umhüllungsmasse (30) als glob-top ausgebildet ist;
- Fig. 2: den schematischen Aufbau eines Halbleitermoduls (10) nach einem Beispiel eines Moduls, das mit Ausnahme der mechanischelektrischen Kontaktzuführungen vollständig von der Umhüllungsmasse (30) umhüllt ist;
- Fig. 3: den schematischen Aufbau eines Halbleitermoduls (10) nach einem Beispiel eines Moduls mit beidseitig des Halbleiters (20) angeordneten Kühlkörpern (80a, 80b) zur Luftkühlung;
- Fig. 4: den schematischen Aufbau eines Halbleitermoduls (10) nach einem Beispiel eines Moduls mit beidseitig des Halbleiters (20) angeordneten Kühlkörpern (80a, 80b) zur Wasserkühlung; und
- Fig. 5: den schematischen Aufbau eines Halbleitermoduls (10) nach einem Beispiel eines Moduls mit einem auf der einen Seite des Halbleiters (20) angeordneten Kühlkörper zur Luftkühlung (80c) und einem auf der anderen Seite des Halbleiters (20) angeordneten Kühlkörper zur Wasserkühlung (80b).

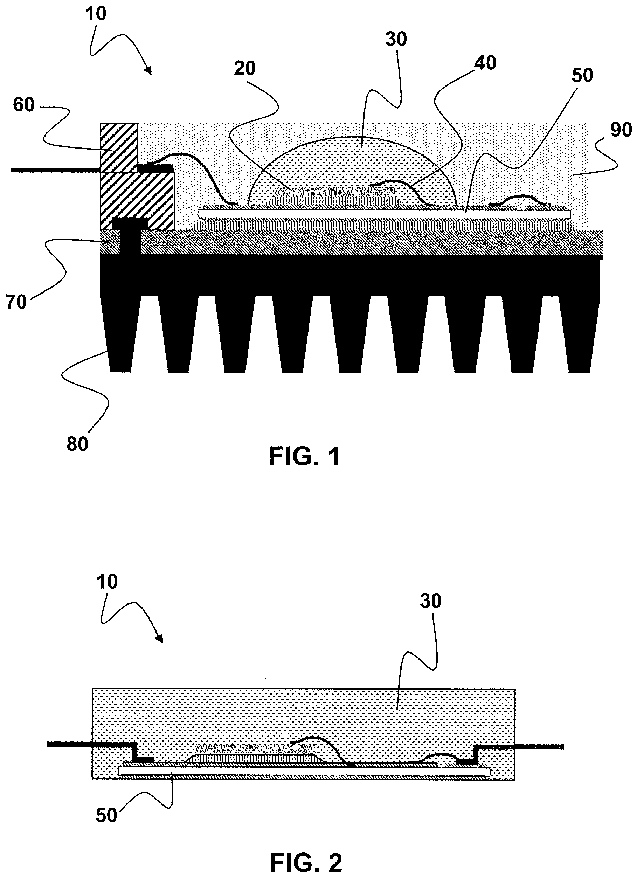

Fig. 1 zeigt ein als leistungselektronische Baugruppe ausgebildetes Halbleitermodul (10) mit einem Halbleiterbaustein (20), der mit einer Umhüllungsmasse (30) bedeckt ist. Bevorzugt sind auch die den Halbleiterbaustein (20) kontaktierenden Bonddrähte (40) mit der Umhüllungsmasse (30) zumindest teilweise, besonders bevorzugt aber vollständig bedeckt bzw. umhüllt.

Der Halbleiterbaustein (20) ist dabei - wie bekannt - auf einem keramischen Schaltungsträger (50) befestigt, der wiederum auf der Oberseite einer Wärmespreizplatte (70) aufgebracht ist, deren Unterseite mit einem Kühlkörper (80) verbunden ist. Darüber hinaus weist das Halbleitermodul (10) einen Rahmen (60) als Träger von nach außen geführten elektrischen Kontakten auf.

Bei diesem ersten Ausführungsbeispiel ist die Umhüllungsmasse (30) lediglich als den Halbleiterbaustein (20) und dessen Bonddrähte (40) bedeckender/umhüllender Tropfen (*"glob-top"*) ausgebildet. Der "*glob-top*" und die weiteren Oberflächenbereiche des Halbleitermoduls (10) sind dabei von einer Isolationsmasse (90), beispielsweise einem Silikongel, bedeckt.

Fig. 2 zeigt ein mit einem rahmenlosen Aufbau konstruiertes Halbleitermodul (10), das mit Ausnahme der elektrischen und thermischen Kontaktflächen vollständig mit der Umhüllungsmasse (30) umhüllt ist.

Diese Ausgestaltung eignet sich insbesondere als Ausgangspunkt für die in den folgenden Figuren gezeigten Beispiele.

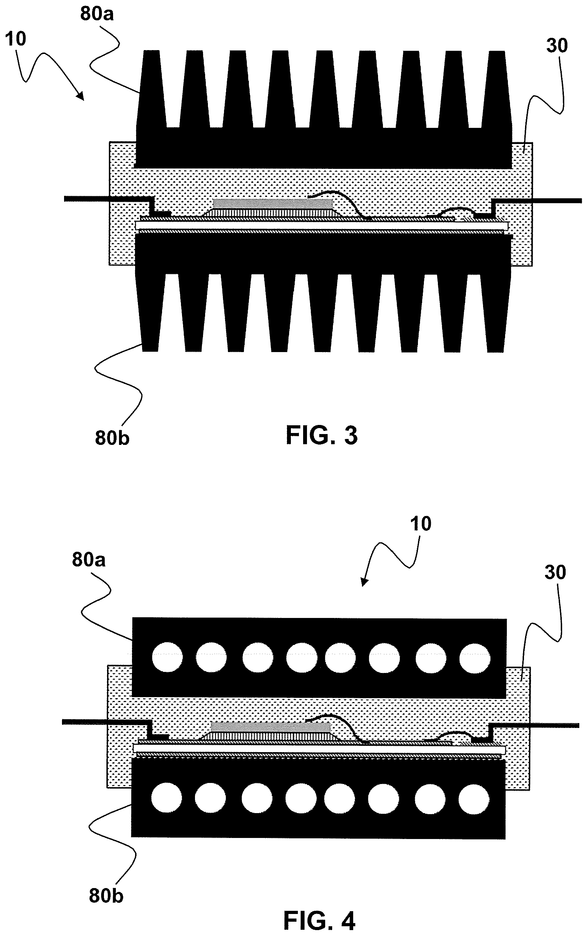

Fig. 3 zeigt eine Leistungsbaugruppe mit einer zweiseitig vorgesehenen Luftkühlung, wobei der obere Kühlkörper (80a) mit einer Wärmebrücke bestehend aus der Umhüllungsmasse (30), die stofflich den Kühlkörper (80a) kontaktiert, und der untere Kühlkörper (80b) durch stoffliche Verbindung zum keramischen Schaltungsträger (50) verbunden ist.

Die dargestellte Kühlerstruktur ist jeweils einstückig und mit Kühlrippen oder Kühlstiften versehen, damit ein Luftdurchtritt möglichst turbulent erfolgt.

Fig. 4 zeigt eine Leistungsbaugruppe mit zweiseitiger Wasserkühlung entsprechend der in Fig. 3 gezeigten Ausgestaltung, wobei die in Fig. 4 dargestellte Kühlerstruktur einstückig ausgebildet und mit inneren Wasserführungskanälen versehen ist, damit ein Wasserdurchtritt möglichst in einer geschlossenen Struktur mit geringer Dichtungslänge erfolgen kann.

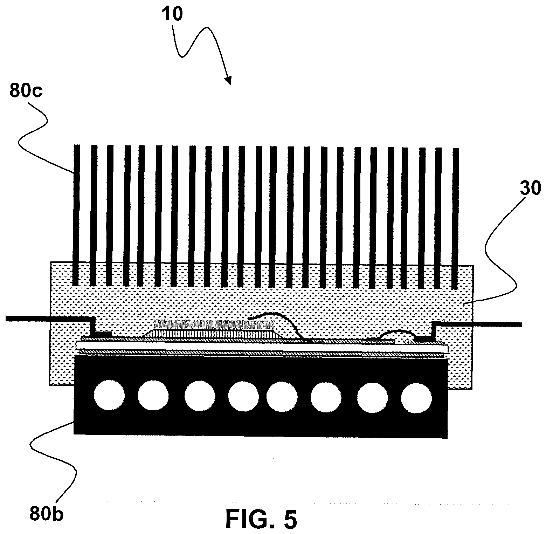

Fig. 5 schließlich zeigt eine Leistungsbaugruppe mit zweiseitiger Kühlung, wobei der untere Kühlkörper (80b) erneut einstückig, der obere Kühlkörper (80c) aber mehrteilig ausgebildet ist. Die als oberer Kühlkörper (80c) dargestellte Kühlerstruktur besteht beispielsweise aus einer Mehrzahl von sich über die Oberseite des Halbleitermoduls (10) erstreckenden Kühlplatten oder einer Mehrzahl von sich über der Oberfläche des Halbleitermoduls (10) verteilenden Kühlstiften.

Das nach dem erfindungsgemäßen Verfahren herstellbare Halbleitermodul (10) weist eine in mehrfacher Hinsicht verbesserte Umhüllungsmasse (30) auf. Zu nennen sind insbesondere ein mit dem keramischen Schaltungsträger harmonierender thermischer Ausdehnungskoeffizient, was sich günstig hinsichtlich Vermeidung unerwünschter Phänomene wie Delaminationen (beispielsweise infolge thermischer Scherspannungen) und Zerstörung der umhüllten Bonddrähte (beispielsweise Abscheren von Bonddrähten) auswirkt. Ein weiterer Vorteil der Umhüllungsmasse (30) ist ihre vergleichsweise gute Wärmeleitfähigkeit als Grundlage einer guten Wärmeableitung aus dem Halbleitermodul (10) bzw. dem mindestens einen Halbleiterbaustein (20) während des bestimmungsgemäßen Betriebs. Auch die Haftung auf den mit der Umhüllungsmasse (30) in Kontakt kommenden Oberflächen ist gut. In letzter Konsequenz bedeuten die genannten Vorteile auch ein insbesondere hinsichtlich Langlebigkeit und mit vergleichsweise hoher elektrischer Leistung möglichem Betrieb verbessertes Halbleitermodul (10).

## Patentansprüche

1. Verfahren zur Herstellung eines als leistungselektronische Baugruppe ausgebildeten Halbleitermoduls (10) mit einem mindestens einen Halbleiterbaustein (20) tragenden keramischen Schaltungsträger (50),
wobei der mindestens eine Halbleiterbaustein (20) von einer einen ausgehärteten anorganischen Zement umfassenden Umhüllungsmasse (30) bedeckt ist,
wobei die Umhüllungsmasse (30) einen thermischen Ausdehnungskoeffizienten im Bereich von 2 bis 10 ppm/K aufweist und
wobei die Keramik des keramischen Schaltungsträgers (50) ausgewählt ist aus der Gruppe, die aus auf Aluminiumoxid, Aluminiumnitrid oder Siliziumnitrid basierenden Keramiken besteht, umfassend die Bildung des ausgehärteten anorganischen Zements durch die Schritte:
(1) Vermischen eines pulverförmigen Gemischs aus anorganischem Bindemittel und anorganischen Zuschlagstoffen mit Wasser zu einer gießfähigen Masse,
(2) Vergießen der so gebildeten gießfähigen Masse, und
(3) folgend Abbinden und Trocknung der vergossenen Masse,
wobei das pulverförmige Gemisch aus anorganischem Bindemittel und anorganischen Zuschlagstoffen ein Magnesiumphosphatzement ist,
wobei der Halbleiterbaustein (20) auf dem keramischen Schaltungsträger (50) befestigt ist,
wobei das Halbleitermodul (10) einen Rahmen (60) als Träger von nach außen geführten elektrischen Kontakten aufweist,
wobei der keramische Schaltungsträger (50) auf der Oberseite einer Wärmespreizplatte (70) aufgebracht ist, deren Unterseite mit einem Kühlkörper (80) verbunden ist,
wobei die Umhüllungsmasse (30) als "glob-top" ausgebildet ist,
wobei die den Halbleiterbaustein (20) kontaktierenden Bonddrähte (40) mit der Umhüllungsmasse (30) zumindest teilweise bedeckt sind,
wobei der "glob-top" und die weiteren Oberflächenbereiche des Halbleitermoduls (10) von einer Isolationsmasse (90) bedeckt sind.

2. Verfahren nach Anspruch 1, wobei die Umhüllungsmasse (30) aus dem ausgehärteten anorganischen Zement besteht.

3. Verfahren nach Anspruch 1 oder 2, **dadurch gekennzeichnet, dass** der Magnesiumphosphatzement ein Magnesiumoxid und Zirkonsilikat enthaltender Magnesiumphosphatzement ist.

4. Verfahren nach Anspruch 1, 2 oder 3, wobei die Isolationsmasse (90) ein Silikongel ist.

## Claims

1. A method for producing a semiconductor module (10) formed as powerelectronic assembly comprising a ceramic interconnect device (50) carrying at least one semiconductor component (20),
wherein the at least one semiconductor component (20) is covered by an encapsulating compound (30) comprising a cured inorganic cement,
wherein the encapsulating compound (30) has a thermal expansion coefficient in the range of from 2 to 10 ppm/K, and
wherein the ceramic of the ceramic interconnect device (50) is selected from the group consisting of ceramics based on aluminium oxide, aluminium nitride, or silicon nitride,
comprising the formation of the cured inorganic cement by means of the steps of:
(1) mixing a powdery mixture of inorganic binding agent and inorganic additives with water to form a pourable mass,
(2) pouring the pourable mass formed in this way, and
(3) then setting and drying the poured mass,
wherein the powdery mixture of inorganic binding agent and inorganic additives is a magnesium phosphate cement,
wherein the semiconductor component (20) is fastened to the ceramic interconnect device (50),
wherein the semiconductor module (10) has a frame (60) as carrier of electrical contacts, which are guided to the outside,
wherein the ceramic interconnect device (50) is attached to the upper side of a heat dissipation plate (70), the underside of which is connected to a cooling element (80),
wherein the encapsulating compound (30) is formed as "glob-top",
wherein the bond wires (40) contacting the semiconductor component (20) are at least partially covered with the encapsulating compound (30),
wherein the "glob-top" and the further surface regions of the semiconductor module (10) are covered by an insulating mass (90).

2. The method according to claim 1, wherein the encapsulating mass (30) consists of the cured inorganic cement.

3. The method according to claim 1 or 2, **characterised in that** the magnesium phosphate cement is a magnesium oxide- and zirconium silicate-containing magnesium phosphate cement.

4. The method according to claim 1, 2 or 3, wherein the insulating mass (90) is a silicone gel.

## Revendications

1. Procédé de fabrication d'un module à semi-conducteur (10) conçu comme bloc électronique de puissance, avec un support de circuit (50) céramique portant au moins un composant à semi-conducteur (20),
au moins un composant à semi-conducteur (20) étant recouvert d'une masse d'enrobage (30) englobant un ciment inorganique durci,
la masse d'enrobage (30) présentant un coefficient de dilatation thermique de l'ordre de 2 à 10 ppm/K et
la céramique du support de circuit (50) céramique étant sélectionnée dans le groupe qui se compose de céramiques basées sur l'oxyde d'aluminium, le nitrure d'aluminium ou le nitrure de silicium, comprenant la formation du ciment inorganique durci par les étapes :
(1) Mélange d'un mélange pulvérulent composé de liant inorganique et d'agrégats inorganiques avec de l'eau en une masse coulable,
(2) Coulage de la masse coulable ainsi formée,
(3) puis prise et séchage de la masse coulée,
le mélange pulvérulent composé de liant inorganique et d'agrégats inorganiques étant un ciment de phosphate de magnésium,
le composant à semi-conducteur (20) étant fixé sur le support de circuit (50) céramique,
le module à semi-conducteur (10) présentant un cadre (60) comme support de contacts électriques guidés vers l'extérieur,
le support de circuit (50) céramique étant appliqué sur la face supérieure d'une plaque de dispersion thermique (70), dont la face inférieure est reliée à un refroidisseur (80),
la masse d'enrobage (30) étant conçue comme « glob-top »,
les fils de connexion (40) en contact avec le composant à semi-conducteur (20) étant recouverts au moins partiellement de la masse d'enrobage (30),
le « glob-top » et les autres zones de surface du module à semi-conducteur (10) étant recouverts d'une masse d'isolation (90).

2. Procédé conformément à la revendication n°1, la masse d'enrobage (30) se composant du ciment inorganique durci.

3. Procédé conformément à la revendication n°1 ou n°2, **caractérisé en ce que** le ciment de phosphate de magnésium est un ciment de phosphate de magnésium contenant de l'oxyde de magnésium et du silicate de zirconium.

4. Procédé conformément à la revendication n°1, n°2 ou n°3, la masse d'isolation (90) étant un gel de silicone.
